# EUROPEAN PATENT APPLICATION

(11) **EP 4 641 619 A1**
(43) Date of publication of application: **29.10.2025**
(21) Application number: 23906408.2
(22) Date of filing: 03.10.2023
(51) Int. Cl.: H01L 21/304

(54) **SUBSTRATE CLEANING DEVICE AND SUBSTRATE CLEANING METHOD**

(30) Priority: 23.12.2022 JP 2022207536
(71) Applicant: SCREEN Holdings Co., Ltd., Kyoto-shi, Kyoto 602-8585 (JP)
(72) Inventor: OKITA, Nobuaki, Kyoto-shi, Kyoto 602-8585 (JP); NAKAMURA, Kazuki, Kyoto-shi, Kyoto 602-8585 (JP); OKADA, Yoshifumi, Kyoto-shi, Kyoto 602-8585 (JP)
(74) Representative: Kilian Kilian & Partner mbB
(86) International application number: PCT/JP2023/036132
(87) International publication number: WO 2024/135033

(57) **Abstract**

A substrate cleaning device includes a first cleaner, a second cleaner, a load adjuster and a control device. The first cleaner cleans a first surface of a substrate. The second cleaner cleans a second surface opposite to the first surface of the substrate. The load adjuster adjusts a load to be applied to the substrate by the first cleaner or the second cleaner. The control device controls the load adjuster such that, a first load is applied to the substrate in a case in which a distance between cleaners which is the distance between the first cleaner and the second cleaner in plan view is larger than a predetermined first distance threshold value, and a second load larger than the first load is applied to the substrate in a case in which the distance between cleaners is equal to or smaller than the first distance threshold value.

## Description

### [Technical Field]

The present invention relates to a substrate cleaning device that cleans a substrate and a substrate cleaning method of cleaning the substrate.

### [Background Art]

A substrate processing apparatus is used to perform various processes on various substrates such as a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate or a substrate for a solar cell. A substrate cleaning device is used to clean a substrate.

For example, Patent Document 1 describes a substrate processing apparatus including a first cleaning body and a second cleaning body. In this substrate processing apparatus, with a substrate rotated by a spin chuck, the upper surface and the lower surface of the substrate are respectively cleaned by the first cleaning body and the second cleaning body. The first cleaning body and the second cleaning body move in synchronization with each other to clean a position at which the first cleaning body and the second cleaning body overlap with each other in the substrate.

[Patent Document 1] JP 2019-106531 A

### [Summary of Invention]

### [Technical Problem]

With the substrate processing apparatus described in Patent Document 1, it is possible to firmly clean the substrate by suppressing deflection of the substrate. However, since the first cleaning body and the second cleaning body need to be moved in synchronization with each other, the first cleaning body and the second cleaning body cannot be moved independently of each other, and the procedure of cleaning for the substrate is limited. Therefore, the substrate cannot be cleaned efficiently.

An object of the present invention is to provide a substrate cleaning device and a substrate cleaning method that enable efficient cleaning for a substrate.

### [Solution to Problem]

A substrate cleaning device according to one aspect of the present invention includes a first cleaner that cleans a first surface of a substrate, a second cleaner that cleans a second surface opposite to the first surface of the substrate, a load adjuster that adjusts a load to be applied to the substrate by the first cleaner or the second cleaner, and a controller that controls the load adjuster such that, in a case in which a distance between cleaners is larger than a predetermined first distance threshold value, a first load is applied to the substrate, and in a case in which the distance between cleaners is equal to or smaller than the first distance threshold value, a second load larger than the first load is applied to the substrate, the distance between cleaners being a distance between the first cleaner and the second cleaner in plan view.

A substrate cleaning method according to another aspect of the present invention including cleaning a first surface of a substrate using a first cleaner, cleaning a second surface opposite to the first surface of the substrate using a second cleaner, adjusting, using a load adjuster, a load to be applied to the substrate by the first cleaner or the second cleaner to a first load in a case in which a distance between cleaners is larger than a predetermined first distance threshold value, the distance between cleaners being a distance between the first cleaner and the second cleaner in plan view, and adjusting, using the load adjuster, a load to be applied to the substrate by the first cleaner or the second cleaner to a second load larger than the first load in a case in which the distance between cleaners is equal to or smaller than the first distance threshold value.

### [Advantageous Effects of Invention]

With the present invention, the substrate can be efficiently cleaned.

### [Brief Description of the Drawings]

[FIG. 1] Fig. 1 is a schematic plan view of a substrate cleaning device according to one embodiment of the present invention.
[FIG. 2] Fig. 2 is a perspective view showing the inner configuration of the substrate cleaning device of Fig. 1.
[FIG. 3] Fig. 3 is a schematic diagram for explaining the configuration of a lower-surface brush driver of Fig. 1.
[FIG. 4] Fig. 4 is a diagram for explaining an operation of a lower-surface cleaning device.
[FIG. 5] Fig. 5 is a schematic diagram for explaining the details of cleaning for a lower-surface outer area of a substrate.
[FIG. 6] Fig. 6 is a schematic diagram for explaining the details of cleaning for the lower-surface outer area of the substrate.
[FIG. 7] Fig. 7 is a schematic diagram for explaining the details of cleaning for the lower-surface outer area of the substrate.
[FIG. 8] Fig. 8 is a block diagram showing the configuration of a control system of the substrate cleaning device.
[FIG. 9] Fig. 9 is a flowchart showing a substrate cleaning process executed by a control device of Fig. 8.
[FIG. 10] Fig. 10 is a flowchart showing a double-side cleaning process of Fig. 9.
[FIG. 11] Fig. 11 is a diagram showing movement of a spray nozzle in a modified example.

### [Description of Embodiments]

A substrate cleaning device and a substrate processing method according to embodiments of the present invention will be described below with reference to the drawings. In the following description, a substrate refers to a semiconductor substrate (wafer), a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like. Further, in the following description, the upper surface of a substrate is a circuit forming surface (obverse surface), and the lower surface of the substrate is the surface opposite to the circuit forming surface (back surface). Further, the substrate has a circular shape except for a notch.

### 1. Configuration of Substrate Cleaning Device

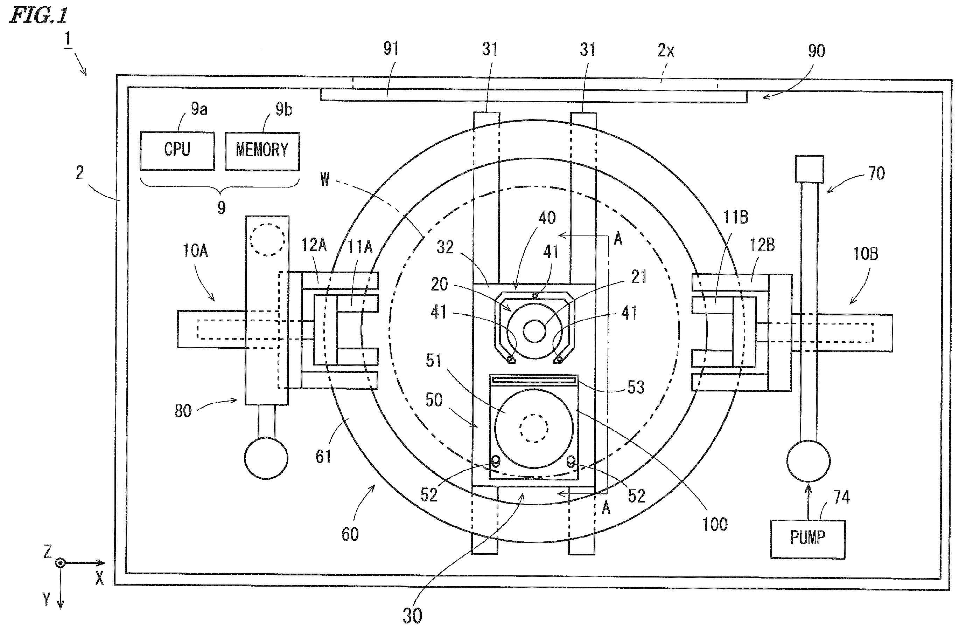

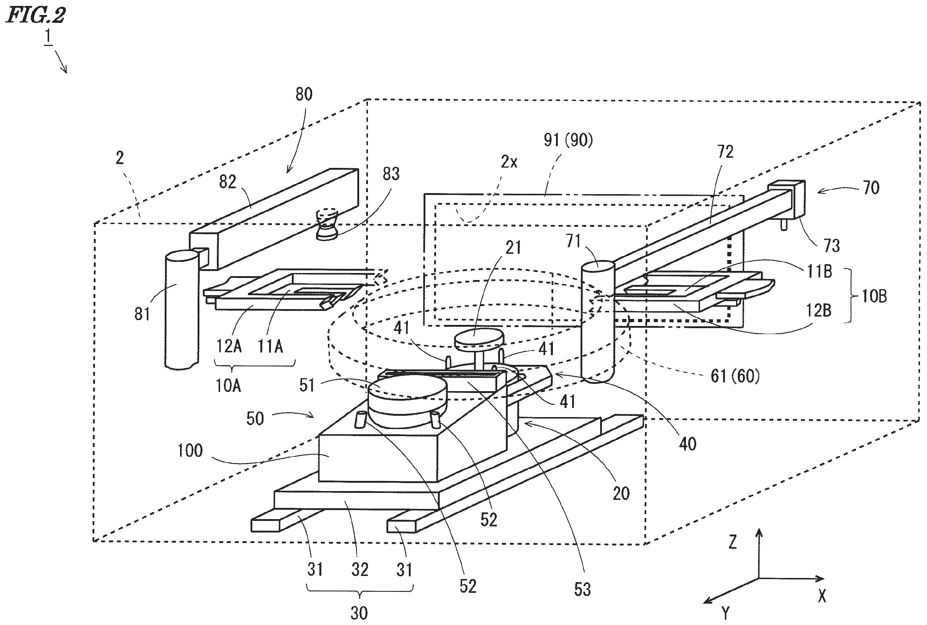

Fig. 1 is a schematic plan view of a substrate cleaning device according to one embodiment of the present invention. Fig. 2 is a perspective view showing the inner configuration of the substrate cleaning device 1 of Fig. 1. In the substrate cleaning device 1 according to the present embodiment, X, Y and Z directions orthogonal to one another are defined for the clarity of a positional relationship. In Fig. 1 and the subsequent drawings, the X, Y and Z directions are suitably indicated by arrows. The X and Y directions are orthogonal to each other within a horizontal plane, and the Z direction corresponds to an upward-and-downward direction (vertical direction).

As shown in Fig. 1 and Fig. 2, the substrate cleaning device 1 has the configuration in which upper holding devices 10A, 10B, a lower holding device 20, a base device 30, a receiving-transferring device 40, a lower-surface cleaning device 50, a cup device 60, an upper-surface cleaning device 70, an end-portion cleaning device 80 and an open-close device 90 are contained in a unit casing 2. In Fig. 2, the unit casing 2 is indicated by the dotted lines.

The unit casing 2 has a rectangular parallelepiped shape and includes a rectangular bottom surface portion and four sidewall portions extending upwardly from four sides of the bottom surface portion. Two of the four sidewall portions face each other in the Y direction. The other two of the four sidewall portions face each other in the X direction. An inlet-outlet port 2x for the substrate W is formed at the center of one of the four sidewalls. The open-close device 90 is provided in the vicinity of the inlet-outlet port 2x. The open-close device 90 includes a shutter 91 and is configured to be capable of opening and closing the inlet-outlet port 2x using the shutter 91.

The base device 30 is provided at the bottom surface of the unit casing 2. The base device 30 includes linear guides 31 and a mobile base 32. The linear guides 31 include two rails arranged in the X direction and extend in the Y direction so as to cross the center portion of the bottom surface portion in the X direction. The base device 30 is configured to be capable of moving the mobile base 32 to a plurality of positions in the Y direction on the two rails of the linear guides 31.

The lower holding device 20 and the lower-surface cleaning device 50 are provided on the mobile base 32 so as to be arranged in the Y direction. The lower holding device 20 is provided on the upper surface of the mobile base 32 and includes a suction holder 21. The suction holder 21 is a so-called spin chuck, and has a circular suction surface capable of holding the lower surface of the substrate W by suction. Further, the suction holder 21 is configured to be rotatable about an axis extending in the upward-and-downward direction (axis extending in the Z direction). The lower holding device 20 sucks the lower surface of the substrate W using the suction holder 21. Thus, the substrate W is held in a substantially horizontal posture. Further, the suction holder 21 rotates the held substrate W about an axis extending in the upward-and-downward direction.

In the following description, an area that is to held by suction by the suction surface of the suction holder 21 in the lower surface of the substrate W when the substrate W is sucked and held by the suction holder 21 is referred to as a lower-surface center area. Further, an area, surrounding the lower-surface center area, in the lower surface of the substrate W is referred to as a lower-surface outer area.

On the mobile base 32, the receiving-transferring device 40 is provided in the vicinity of the lower holding device 20. The receiving-transferring device 40 has a plurality (three in the present example) of support pins 41 that are provided to surround the suction holder 21 in plan view and extend in the upward-and-downward direction. The plurality of support pins 41 are provided so as to be liftable and lowerable among a plurality of predetermined height positions.

As described below, the upper holding devices 10A, 10B are configured to be capable of holding the substrate W in a substantially horizontal posture at a position higher than the lower holding device 20. By lifting and lowering the plurality of support pins 41, the receiving-transferring device 40 can receive the substrate W held by the lower holding device 20 and transfer the substrate W to the upper holding devices 10A, 10B. Further, the receiving-transferring device 40 can receive the substrate W held by the upper holding devices 10A, 10B and transfer the substrate W to the lower holding device 20.

The lower-surface cleaning device 50 includes a lower-surface brush 51, two liquid nozzles 52, a gas injector 53 and a lower-surface brush driver 100. The lower-surface brush driver 100 is provided on the upper surface of the mobile base 32 so as to be adjacent to the lower holding device 20 in the Y direction. As shown in Fig. 1, the lower-surface brush 51 has a circular cleaning surface that can come into contact with the lower surface of the substrate W. Further, the lower-surface brush 51 is attached to the lower-surface brush driver 100 such that the cleaning surface is directed upwardly and the cleaning surface is rotatable about an axis extending in the upward-and-downward direction through the center of the cleaning surface. The area of the cleaning surface of the lower-surface brush 51 is larger than the area of the suction surface of the suction holder 21. The lower-surface brush 51 is formed of a PVA (polyvinyl alcohol) sponge or a PVA sponge in which abrasive grains are dispersed, for example.

The lower-surface brush driver 100 includes a lifting-lowering mechanism that lifts and lowers the lower-surface brush 51 and a brush driving mechanism that rotates the lower-surface brush 51. The lower-surface brush driver 100 is lifted and lowered by the lifting-lowering mechanism with the substrate W held by the lower holding device 20 or the upper holding devices 10A, 10B. Thus, the lower-surface brush driver 100 moves the lower-surface brush 51 between a height position at which the lower-surface brush 51 comes into contact with the lower surface of the substrate W and a height position at which the lower-surface brush 51 is spaced apart from the substrate W by a certain distance.

Further, the lower-surface brush driver 100 rotates the lower-surface brush 51 using the brush driving mechanism. Thus, the lower-surface brush 51 rotates while being located at the height position at which the lower-surface brush 51 comes into contact with the lower surface of the substrate W, so that a portion of the lower surface of the substrate W that comes into contact with the lower-surface brush 51 is cleaned. Details of the lower-surface brush driver 100 will be described below.

Each of the two liquid nozzles 52 is attached to a casing-shaped container, described below, of the lower-surface brush driver 100 such that the two liquid nozzles 52 are located in the vicinity of the lower-surface brush 51 and the liquid outlet ports are directed upwardly. A cleaning liquid supply system (not shown) is connected to the liquid nozzles 52. When the substrate W is cleaned by the lower-surface brush 51, the liquid nozzles 52 discharge the cleaning liquid supplied from the cleaning liquid supply system to the lower surface of the substrate W. In the present embodiment, pure water is used as the cleaning liquid to be supplied to the liquid nozzles 52.

The gas injector 53 is a slit-like gas injection nozzle having a gas injection port extending in one direction. The gas injector 53 is attached to the container of the lower-surface brush driver 100 such that the gas injector 53 is located between the lower-surface brush 51 and the suction holder 21 in plan view and the gas injection port is directed upwardly. An injection gas supply system (not shown) is connected to the gas injector 53. In the present embodiment, a nitrogen gas is used as the gas to be supplied to the gas injector 53. The gas injector 53 injects the gas supplied from the injection gas supply system to the lower surface of the substrate W during cleaning for the substrate W by the lower-surface brush 51 and during drying for the lower surface of the substrate W, described below. Thus, a strip-shaped gas curtain extending in the X direction is formed between the lower-surface brush 51 and the suction holder 21.

The cup device 60 is provided at a substantially center portion in the unit casing 2 and includes a cup 61. The cup 61 is provided to surround the lower holding device 20 and the base device 30 in plan view and be liftable and lowerable. In Fig. 2, the cup 61 is indicated by the dotted lines. The cup 61 moves between a predetermined lower cup position and a predetermined upper cup position in accordance with which portion of the lower surface of the substrate W is to be cleaned by the lower-surface brush 51. The lower cup position is a height position at which the upper end portion of the cup 61 is located below the substrate W held by suction by the suction holder 21. Further, the upper cup position is a height position at which the upper end portion of the cup 61 is located above the suction holder 21.

The upper holding devices 10A, 10B are provided at a height position higher than the cup 61. The upper holding devices 10A, 10B are opposite to each other with the base device 30 interposed therebetween in plan view. The upper holding device 10A includes a lower chuck 11A and an upper chuck 12A. The upper holding device 10B includes a lower chuck 11B and an upper chuck 12B.

The lower chucks 11A, 11B are arranged symmetrically with respect to a vertical plane extending in the Y direction through the center of the suction holder 21 in plan view, and are provided to be movable in the X direction in a common horizontal plane. Each of the lower chucks 11A, 11B has two support pieces that can support the lower-surface outer area of the substrate W from below the substrate W. Similarly to the lower chucks 11A, 11B, the upper chucks 12A, 12B are arranged symmetrically with respect to the vertical plane extending in the Y direction through the center of the suction holder 21 in plan view, and are provided to be movable in the X direction in a common horizontal plane. Each of the upper chucks 12A, 12B has two holding pieces that are configured to abut against two portions of the outer peripheral end of the substrate W and be capable of holding the outer peripheral end of the substrate W.

In the upper holding devices 10A, 10B, the distance between the lower chuck 11A and the upper chuck 12A and the distance between the lower chuck 11B and the upper chuck 12B are adjusted. Thus, the upper holding devices 10A, 10B can hold the substrate W at a position above the lower holding device 20 by holding the substrate W between the lower chuck 11A and the upper chuck 12A and between the lower chuck 11B and the upper chuck 12B. Further, in the upper holding devices 10A, 10B, it is possible to release the held substrate W by moving the lower chuck 11A and the upper chuck 12A away from each other and moving the lower chuck 11B and the upper chuck 12B away from each other.

As shown in Fig. 1, the upper-surface cleaning device 70 is provided at a position near one side of the cup 61 in the X direction. As shown in Fig. 2, the upper-surface cleaning device 70 includes a rotation support shaft 71, an arm 72, a spray nozzle 73 and a pump 74 (Fig. 1). The rotation support shaft 71 is provided so as to extend in the upward-and-downward direction and to be liftable, lowerable and rotatable. At a position above the upper holding devices 10A, 10B, the arm 72 is provided to extend in the horizontal direction from the upper end portion of the rotation support shaft 71. The spray nozzle 73 is attached to the tip portion of the arm 72.

A fluid supply system (not shown) is connected to the spray nozzle 73. A cleaning liquid supplied from the fluid supply system (not shown) is pumped to the spray nozzle 73 by the pump 74. Further, gas is supplied from the fluid supply system to the spray nozzle 73. Thus, the cleaning liquid and the gas are mixed in the spray nozzle 73, and a fluid mixture is generated. The generated fluid mixture is injected downwardly from the spray nozzle 73.

In the upper-surface cleaning device 70, the height position of the rotation support shaft 71 is adjusted and the rotation support shaft 71 is rotated such that the spray nozzle 73 moves above the substrate W with the substrate W held and rotated by the lower holding device 20, for example. In this state, the fluid mixture is injected from the spray nozzle 73 to the substrate W. Thus, the entire upper surface of the substrate W is cleaned.

As shown in Fig. 1, the end-portion cleaning device 80 is provided at a position near the other side of the cup 61 in the X direction. As shown in Fig. 2, the end-portion cleaning device 80 includes a rotation support shaft 81, an arm 82 and a bevel brush 83. The rotation support shaft 81 is provided so as to extend in the upward-and-downward direction and to be liftable, lowerable and rotatable. At a position above the upper holding devices 10A, 10B, the arm 82 is provided to extend in the horizontal direction from the upper end portion of the rotation support shaft 81. At the tip portion of the arm 82, the bevel brush 83 is provided to project downwardly and be rotatable about an axis extending in the upward-and-downward direction.

In the end-portion cleaning device 80, the height position of the rotation support shaft 81 is adjusted and the rotation support shaft 81 is rotated such that the bevel brush 83 comes into contact with the outer peripheral end of the substrate W with the substrate W held and rotated by the lower holding device 20, for example. Further, the bevel brush 83 provided at the tip portion of the arm 82 rotates about an axis extending in the upward-and-downward direction. Thus, the entire outer peripheral end of the substrate W is cleaned.

As shown in Fig. 1, the substrate cleaning device 1 further includes a control device 9. The control device 9 includes a CPU (Central Processing Unit) 9a and a memory 9b, for example. The control device 9 may be realized by a microcomputer. The memory 9b stores a substrate cleaning program. The CPU 9a controls the operations of the respective above-mentioned constituent elements (10A, 10B, 20, 30, 40, 50, 60, 70, 80, 90) by executing the substrate cleaning program stored in the memory 9b.

### 2. Lower-surface Brush Driver

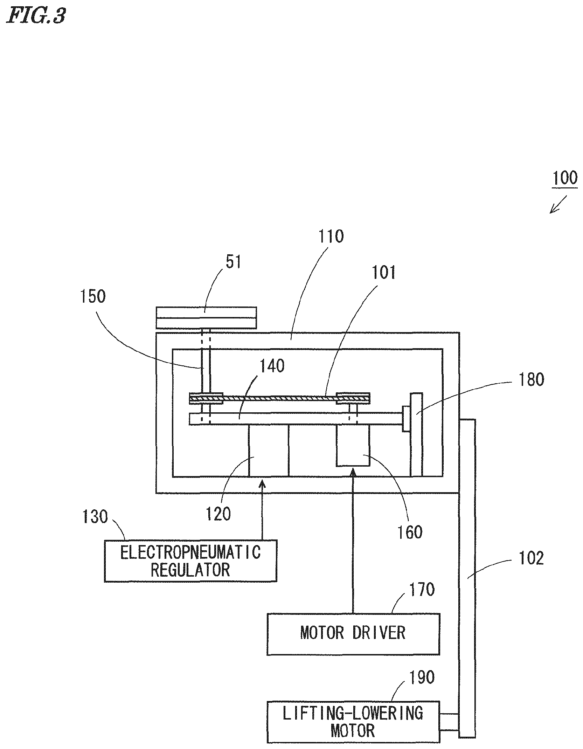

Fig. 3 is a schematic diagram for explaining the configuration of the lower-surface brush driver 100 of Fig. 1. Fig. 3 is a schematic side view showing the configuration of the lower-surface brush 51 and its peripheral members. As shown in Fig. 3, the lower-surface brush driver 100 includes a container 110, an air cylinder 120, an electropneumatic regulator 130, a support member 140, a rotation shaft 150, a rotation motor 160, a motor driver 170, a linear guide 180 and a lifting-lowering motor 190.

The container 110 is a casing member, for example, and is provided on the upper surface of the mobile base 32. While the liquid nozzles 52 and the gas injector 53 of Fig. 1 are provided on the upper surface of the container 110, the liquid nozzles 52 and the gas injector 53 are not shown in Fig. 3. The container 110 contains the configuration of the lower-surface brush driver 100 excluding the electropneumatic regulator 130, the motor driver 170 and the lifting-lowering motor 190. Thus, it is possible to prevent particles generated by driving of the lower-surface brush 51 from splashing in the unit casing 2. The electropneumatic regulator 130 and the motor driver 170 may also be contained in the container 110.

The air cylinder 120 is provided on the bottom surface of the container 110. The support member 140 is a rod member or a plate member extending in the horizontal direction, and has one end portion and the other end portion. The air cylinder 120 supports a substantially center portion of the support member 140 between the one end portion and the other end portion. The electropneumatic regulator 130 is connected to the air cylinder 120. Air is supplied through the electropneumatic regulator 130, so that the air cylinder 120 lifts and lowers the support member 140 in a predetermined range. An amount of air to be supplied to the air cylinder 120 changes, so that a load to be applied to the support member 140 from the air cylinder 120 changes.

The rotation shaft 150 is provided at one end portion of the support member 140 so as to extend upwardly and be rotatable. The upper end portion of the rotation shaft 150 projects upwardly from the container 110. The lower-surface brush 51 is attached to the upper end portion of the rotation shaft 150 projecting from the container 110. A load to be applied to the above-mentioned support member 140 is changed, so that a load to be applied to the substrate W from the lower-surface brush 51 can be adjusted.

The rotation motor 160 is attached to the vicinity of the other end portion of the support member 140 with the rotation shaft extending in the upward-and-downward direction. The motor driver 170 is connected to the rotation motor 160. A power transmission member 101 is provided between the rotation shaft 150 and the rotation shaft of the rotation motor 160. The power transmission member 101 includes two pulleys respectively attached to the rotation shaft 150 and the rotation shaft of the rotation motor 160, and a belt connecting the two pulleys, and transmits a rotational force generated by the rotation motor 160 to the rotation shaft 150. Thus, the lower-surface brush 51 is rotated.

The linear guide 180 is provided on the bottom surface of the container 110 so as to extend in the upward-and-downward direction. The end portion (the other end portion in the example of Fig. 3) of the support member 140 is connected to the linear guide 180. The linear guide 180 restricts the movement direction of the support member 140 to the upward-and-downward direction.

The lifting-lowering motor 190 has a drive shaft that is liftable and lowerable in the upward-and-downward direction, and is provided outside of the container 110. A power transmission member 102 is provided between the drive shaft of the lifting-lowering motor 190 and the container 110. The power transmission member 102 transmits a driving force generated by the lifting-lowering motor 190 to the container 110. Thus, the lower-surface brush 51 is lifted and lowered together with the container 110 and the stored object. The range in which the lower-surface brush 51 is lifted and lowered by the lifting-lowering motor 190 is larger than the range in which the lower-surface brush 51 is lifted and lowered by the air cylinder 120.

Before the substrate W is cleaned, the lower-surface brush 51 is lowered by the lifting-lowering motor 190. The position of the lower-surface brush 51 at this time is referred to as a waiting position. The waiting position is below the substrate W held by the suction holder 21 of Fig. 1, and the lower-surface brush 51 is largely spaced apart from the substrate W while being located at the waiting position. On the other hand, when the lower surface of the substrate W is cleaned, the lower-surface brush 51 is lifted by the lifting-lowering motor 190. The position of the lower-surface brush 51 at this time is referred to as a processing position. At the processing position, the lower-surface brush 51 is located close to the substrate W. The cleaning for the lower-surface center area and the lower-surface outer area of the substrate W by the lower-surface cleaning device 50 will be described below.

### 3. Operation of Lower-Surface Cleaning Device

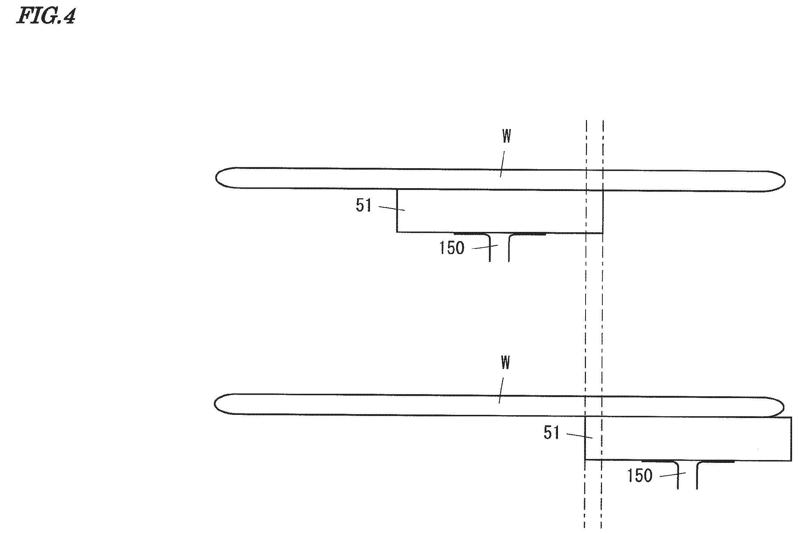

Fig. 4 is a diagram for explaining the operation of the lower-surface cleaning device 50. When the lower-surface center area of the substrate W is cleaned, the cleaning surface of the lower-surface brush 51 is brought into contact with the lower-surface center area of the substrate W held by the upper holding devices 10A, 10B of Fig. 1 as shown in the upper field of Fig. 4. The lower-surface brush 51 is rotated in this state, so that contaminants adhering to the lower-surface center area of the substrate W are removed. Although the substrate W is not rotated when the lower-surface center area of the substrate W is cleaned in the present example, the substrate W may be rotated.

As shown in the lower field of Fig. 4, when the lower-surface outer area of the substrate W is cleaned, the lower-surface brush 51 is brought into contact with the lower-surface outer area of the substrate W held by the suction holder 21 of Fig. 1. At this time, part of the lower-surface brush 51 may project slightly outwardly from the substrate W. The substrate W is rotated in this state, so that contaminants adhering to the lower-surface outer area of the substrate W are removed. Although the lower-surface brush 51 is not rotated when the lower-surface outer area of the substrate W is cleaned in the present example, the lower-surface brush 51 may be rotated.

In the present example, the diameter of the lower-surface brush 51 is larger than 1/3 of the diameter of the substrate W and smaller than 1/2 of the diameter of the substrate W. In this case, the cleaning surface of the lower-surface brush 51 sequentially comes into contact with the lower-surface center area and the lower-surface outer area of the substrate W, so that the entire lower surface of the substrate W is efficiently cleaned. Therefore, the lower-surface brush 51 does not have to be excessively large. The diameter of the substrate W is 300 mm, for example. As indicated by the one-dot and dash lines in Fig. 4, an area that can be cleaned when the cleaning surface of the lower-surface brush 51 comes into contact with the lower-surface center area of the substrate W may slightly overlap with an area that can be cleaned when the cleaning surface of the lower-surface brush 51 comes into contact with the lower-surface outer area of the substrate W.

When the lower surface of the substrate W is cleaned, the cleaning liquid is supplied to the lower surface of the substrate W by the liquid nozzles 52 of Fig. 1. In this case, contaminants adhering to the lower surface of the substrate W can be removed more efficiently. Further, when the lower-surface center area of the substrate W is cleaned, the upper surface of the substrate W and the outer peripheral end of the substrate W are also cleaned at the same time.

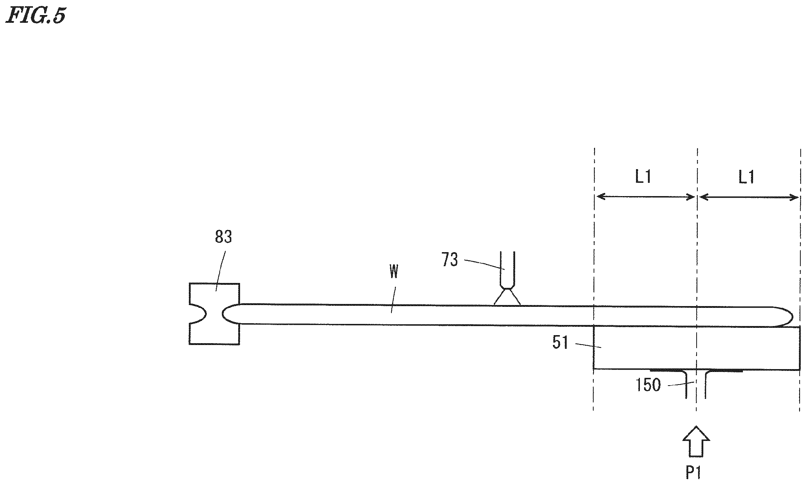

Figs. 5 to 7 are schematic diagrams for explaining the details of cleaning for the lower-surface outer area of the substrate W. As shown in Fig. 5, when the lower-surface outer area of the substrate W is cleaned, a groove portion having a substantially U-shaped cross section and provided at the outer peripheral surface of the bevel brush 83 comes into contact with the outer peripheral end of the rotating substrate W. Thus, the outer peripheral end of the substrate W is cleaned.

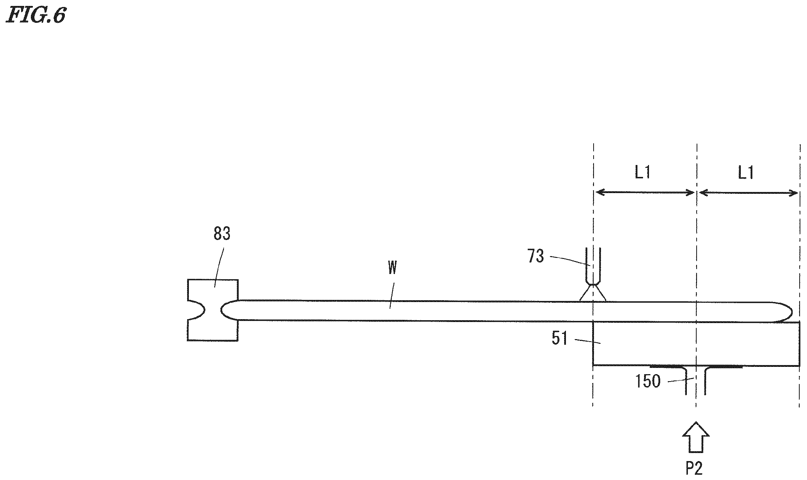

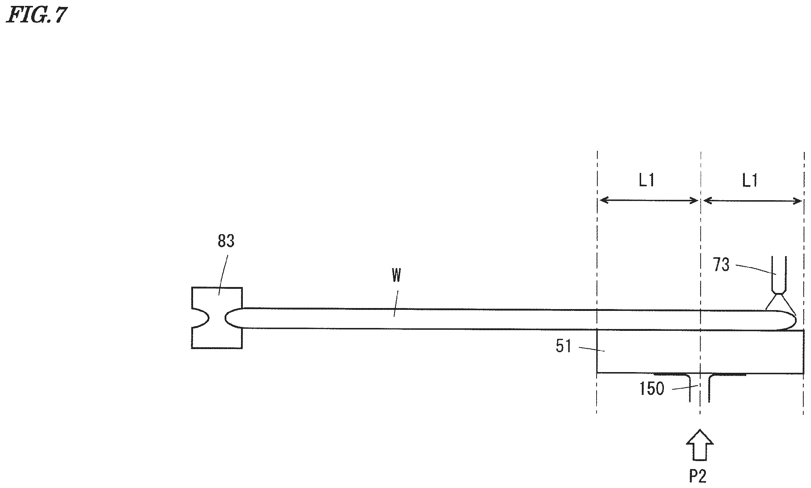

Further, the spray nozzle 73 is moved to a position above substantially the center of the substrate W. In this state, the fluid mixture of the cleaning liquid and the gas is injected from the spray nozzle 73 to the upper surface of the substrate W. Next, as shown in Fig. 6, the spray nozzle 73 is moved outwardly above the rotating substrate W. This movement of the spray nozzle 73 continues until the spray nozzle 73 arrives at a position above the outer periphery of the substrate W as shown in Fig. 7. Thus, the upper surface of the substrate W is cleaned.

Here, a load to be applied to the substrate W by the lower-surface brush 51 is adjusted by the air cylinder 120 of Fig. 3 in accordance with the positional relationship between the lower-surface brush 51 and the spray nozzle 73 in plan view. Specifically, in a case in which the distance between the center of the lower-surface brush 51 and the center of the spray nozzle 73 in plan view (hereinafter referred to as a distance between cleaners) is larger than a predetermined distance threshold value L1, a load to be applied from the lower-surface brush 51 to the substrate W is adjusted to P1 (Fig. 5).

On the other hand, in a case in which the distance between cleaners is equal to or smaller than the distance threshold value L1, a load to be applied to the substrate W by the lower-surface brush 51 is adjusted to P2 larger than the P1 (Figs. 6 and 7). In the present example, the distance threshold value L1 is equal to the radius of the lower-surface brush 51. The distance threshold value L1 may be equal to or smaller than the radius of the lower-surface brush 51. In these cases, when the center of the spray nozzle 73 overlaps with the lower-surface brush 51 in plan view, the relatively large load P2 is applied to the substrate W by the lower-surface brush 51.

### 4. Configuration of Controller

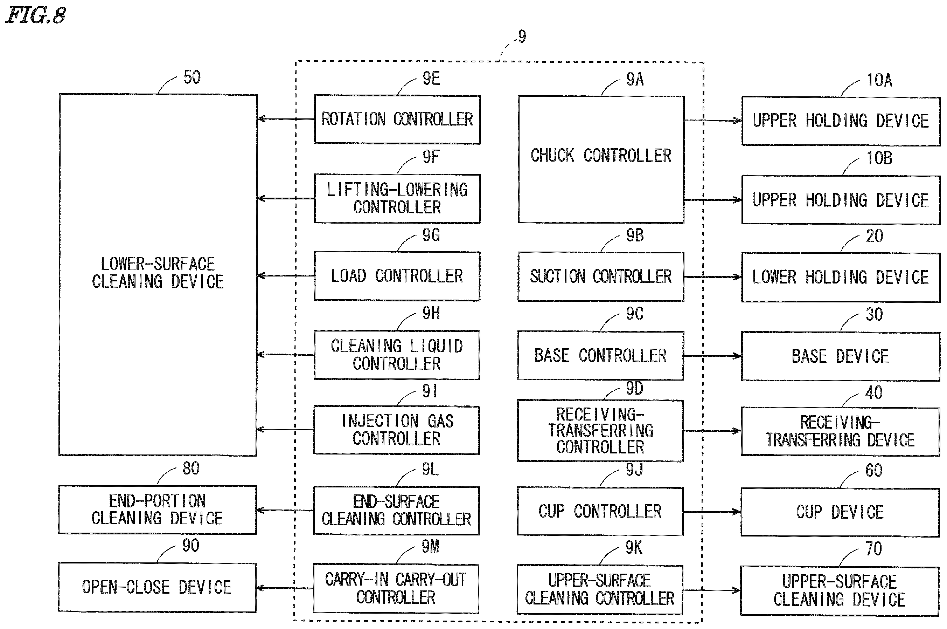

Fig. 8 is a block diagram showing the configuration of a control system of the substrate cleaning device 1. As shown in Fig. 8, the control device 9 includes, as functions, a chuck controller 9A, a suction controller 9B, a base controller 9C, a receiving-transferring controller 9D, a rotation controller 9E, a lifting-lowering controller 9F, a load controller 9G, a cleaning liquid controller 9H, a discharge gas controller 9I, a cup controller 9J, an upper-surface cleaning controller 9K, an end-portion cleaning controller 9L and a carry-in carry-out controller 9M.

The above-mentioned functions of the control device 9 are implemented by execution of the substrate cleaning program stored in the memory 9b (Fig. 1) of the CPU 9a (Fig. 1) of the control device 9. Part or all of the functions of the control device 9 may be implemented by hardware such as an electronic circuit.

The chuck controller 9A controls the upper holding devices 10A, 10B such that the lower chucks 11A, 11B and the upper chucks 12A, 12B hold the substrate W. The suction controller 9B controls the lower holding device 20 such that the suction holder 21 sucks and holds the substrate W and rotates the sucked and held substrate W. The base controller 9C controls the base device 30 such that the mobile base 32 moves to a plurality of positions in the Y direction. The receiving-transferring controller 9D controls the receiving-transferring device 40 such that the plurality of support pins 41 move the substrate W between the upper holding devices 10A, 10B and the lower holding device 20.

The rotation controller 9E controls the motor driver 170 of the lower-surface cleaning device 50 such that the lower-surface brush 51 rotates. The lifting-lowering controller 9F controls the lifting-lowering motor 190 of the lower-surface cleaning device 50 such that the lower-surface brush 51 moves between the waiting position and the processing position. The load controller 9G controls the electropneumatic regulator 130 of the lower-surface cleaning device 50 such that the lower-surface brush 51 applies a predetermined load to the substrate W. The cleaning liquid controller 9H controls the lower-surface cleaning device 50 such that the liquid nozzles 52 discharge the cleaning liquid. The discharge gas controller 9I controls the lower-surface cleaning device 50 such that the gas injector 53 injects gas.

The cup controller 9J controls the cup device 60 such that the cup 61 moves between the lower cup position and the upper cup position. The upper-surface cleaning controller 9K controls the upper-surface cleaning device 70 such that the spray nozzle 73 cleans the upper surface of the substrate W. The end-portion cleaning controller 9L controls the end-portion cleaning device 80 such that the bevel brush 83 cleans the outer peripheral end of the substrate W. The carry-in carry-out controller 9M controls the open-close device 90 such that the shutter 91 opens and closes the inlet-outlet port 2x of the unit casing 2.

### 5. Substrate Cleaning Process

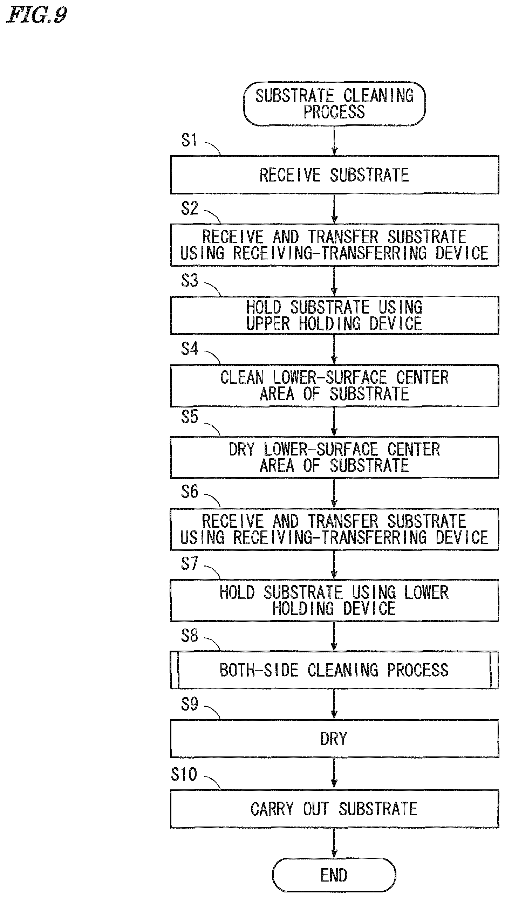

Fig. 9 is a flowchart showing a substrate cleaning process executed by the control device 9 of Fig. 8. The substrate cleaning process is executed by execution of the substrate cleaning program stored in the memory 9b by the CPU 9a of the control device 9. In an initial state, in the base device 30, the mobile base 32 is positioned such that the suction holder 21 of the lower holding device 20 is located at the center of the cup 61 in plan view.

First, by controlling the open-close device 90, the carry-in carry-out controller 9M opens the inlet-outlet port 2x and receives the substrate W that has been carried in from outside of the substrate cleaning device 1 into the unit casing 2 (step S1).

Next, by controlling the receiving-transferring device 40, the receiving-transferring controller 9D receives the substrate W by using the plurality of support pins 41 and transfer the received substrate W to the upper holding device 10A, 10B (step S2). At this time, by controlling the upper holding devices 10A, 10B, the chuck controller 9A holds the outer peripheral end of the substrate W at a position above the lower holding device 20 (step S3). In a case in which the substrate W carried in from outside of the substrate cleaning device 1 can be placed on the lower chucks 11A, 11B, the step S2 may be omitted. The inlet-outlet port 2x opened in the step S1 is closed by the shutter 91 after the substrate W is received by the receiving-transferring device 40.

Thereafter, the rotation controller 9E, the lifting-lowering controller 9F and the load controller 9G respectively control the motor driver 170, the lifting-lowering motor 190 and the electropneumatic regulator 130, and the cleaning liquid controller 9H controls the lower-surface cleaning device 50, whereby the lower-surface center area of the substrate W is cleaned (step S4). Specifically, after the lower-surface brush 51 is lifted from the waiting position to the processing position, the cleaning surface of the lower-surface brush 51 is brought into contact with the lower-surface center area of the substrate W. In this state, the lower-surface brush 51 is rotated. Further, the cleaning liquid is supplied to the lower-surface center area of the substrate W by the liquid nozzles 52. Thus, the lower-surface center area of the substrate W is cleaned by the lower-surface brush 51 impregnated with the cleaning liquid.

During the cleaning in the step S4, the cleaning liquid adheres to the lower-surface center area of the substrate W. As such, the base controller 9C controls the base device 30, and the discharge gas controller 9I controls the lower-surface cleaning device 50, whereby the lower-surface center area of the substrate W is dried (step S5). Specifically, the gas injector 53 injects gas toward the lower surface of the substrate W. Therefore, with a generated gas curtain, the gas injector 53 moves with respect to the lower surface of the substrate W such that the gas curtain passes through the lower-surface center area in plan view. Thus, the cleaning liquid adhering to the lower-surface center area of the substrate W is pushed out to a position outside of the lower-surface center area of the substrate W, and the lower-surface center area is dried.

After the steps S4 and S5 end, the lower-surface brush 51 is lowered from the processing position to the waiting position. Next, by controlling the receiving-transferring device 40, the receiving-transferring controller 9D receives the substrate W held by the upper holding devices 10A, 10B using the plurality of support pins 41 and transfer the received substrate W to the lower holding device 20 (step S6).

Next, by controlling the lower holding device 20, the suction controller 9B holds the lower-surface center area of the substrate W by suction using the suction holder 21 (step S7). During the steps S6 and S7, the base device 30 is positioned such that the center of the substrate W is located at the center of the suction holder 21 in plan view. Thus, the substrate W is held by suction by the suction holder 21 with the center of the substrate W being located on the rotation center (rotation axis) of the suction holder 21.

Further, the control device 9 executes a double-side cleaning process (step S8). In the double-side cleaning process, the entire upper surface and the lower-surface outer area of the substrate W are cleaned at the same time. Further, in the present example, the outer peripheral end of the substrate W is also cleaned at the same time in the double-side cleaning process. Details of the double-side cleaning process in the step S8 will be described below.

After the cleaning for the entire upper surface, the outer peripheral end and the lower-surface outer area of the substrate W ends, the suction controller 9B rotates the substrate W at a high speed and dries the entire substrate W by controlling the lower holding device 20 (step S9). A drying method of drying the entire substrate W by rotating the substrate W at a high speed is referred to as spin drying.

Finally, the carry-in carry-out controller 9M opens the inlet-outlet port 2x by controlling the open-close device 90. Thus, the substrate W is carried out of the substrate cleaning device 1 (step S10), and the substrate cleaning process ends. The inlet-outlet port 2x that is opened in the step S10 is closed by the shutter 91 after the substrate W is carried out.

The cup controller 9J holds the cup 61 at the upper cup position by controlling the cup device 60 during the steps S8 and S9 in the series of above-mentioned process. Thus, liquid droplets splashing from the substrate W during the cleaning for the entire upper surface, the outer peripheral end and the lower-surface outer area of the substrate W and during the spin drying for the substrate W are received by the cup 61 and discharged to the outside of the substrate cleaning device 1. Further, the cup controller 9J holds the cup 61 at the lower cup position by controlling the cup device 60 during the process excluding the steps S8 and S9 in the series of above-mentioned process.

### 6. Double-Side Cleaning Process

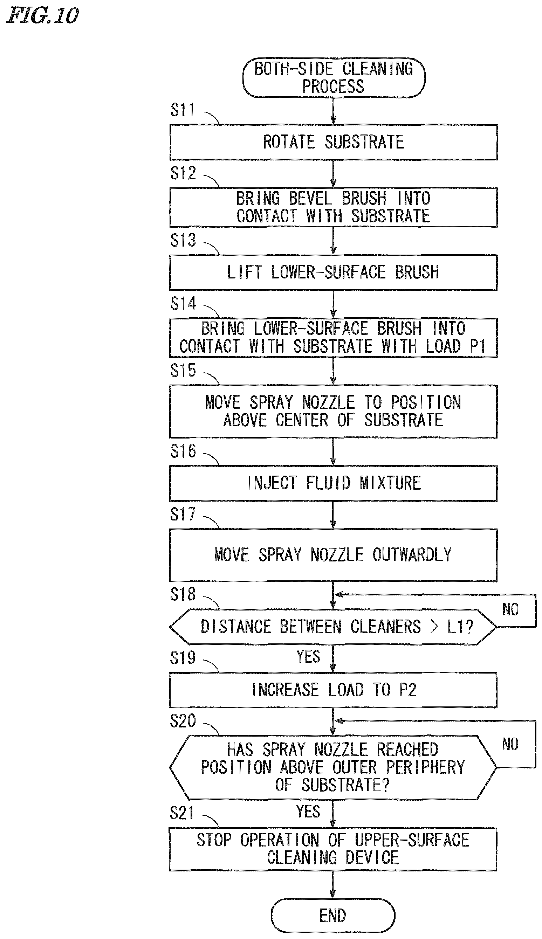

Fig. 10 is a flowchart showing the double-side cleaning process of Fig. 9. The double-side cleaning process will be described below with reference to the lower-surface brush driver 100 of Fig. 3, the control device 9 of Fig. 8, and the substrate W of Figs. 5 to 7.

In the double-side cleaning process, by controlling the lower holding device 20, the suction controller 9B rotates the substrate W held by the suction holder 21 (step S11). Further, by controlling the end-portion cleaning device 80, the end-portion cleaning controller 9L brings the bevel brush 83 into contact with the outer peripheral end of the substrate W (step S12). Thus, the outer peripheral end of the substrate W is cleaned.

Further, by controlling the lifting-lowering motor 190, the lifting-lowering controller 9F lifts the substrate W from the waiting position to the processing position (step S13). Next, by controlling the electropneumatic regulator 130, the load controller 9G brings the lower-surface brush 51 into contact with the lower-surface outer area of the substrate W with a load P1 (step S14). That is, the load P1 is applied to the lower-surface outer area of the substrate W by the lower-surface brush 51. Thus, the lower-surface outer area of the substrate W is cleaned.

Further, by controlling the upper-surface cleaning device 70, the upper-surface cleaning controller 9K moves the spray nozzle 73 to a position above the center of the substrate W (step S15). Next, the upper-surface cleaning controller 9K causes a fluid mixture to be sprayed from the spray nozzle 73 to the upper surface of the substrate W (step S16). In this state, the upper-surface cleaning controller 9K moves the spray nozzle 73 outwardly above the substrate W (step S17). In the present example, the spray nozzle 73 moves to be close to the lower-surface brush 51. The movement of the spray nozzle 73 continues until the spray nozzle 73 reaches to a position above the outer periphery of the substrate W. Thus, the entire upper surface of the substrate W is cleaned.

The cleaning for the outer peripheral end of the substrate W in the step S12, the cleaning for the lower-surface outer area of the substrate W in the steps S13 and S14, and the cleaning for the entire upper surface of the substrate W in the steps S15 to S17 are executed at the same time. Because the step S17 is executed, the distance between cleaners is reduced.

The load controller 9G determines whether the distance between cleaners is larger than the distance threshold value L1 (step S18). In a case in which the distance between cleaners is larger than the distance threshold value L1, the load controller 9G waits until the distance between cleaners reaches a value equal to or smaller than the distance threshold value L1 with the load P1 kept applied to the substrate W. In a case in which the distance between cleaners is equal to or smaller than the distance threshold value L1, the load controller 9G increases a load to be applied to the substrate W to P2 by controlling the electropneumatic regulator 130 (step S19).

After the step S19 is executed, the upper-surface cleaning controller 9K determines whether the spray nozzle 73 has reached to a position above the outer periphery of the substrate W (step S20). In a case in which the spray nozzle 73 has not reached a position above the outer periphery of the substrate W, the upper-surface cleaning controller 9K waits until the spray nozzle 73 reaches a position above the outer periphery of the substrate W. In a case in which the spray nozzle 73 has reached a position above the outer periphery of the substrate W, the cleaning for the entire upper surface of the substrate W ends. In this case, the upper-surface cleaning controller 9K stops the operation of the upper-surface cleaning device 70 (step S21).

Because the step S21 is executed, injection of the fluid mixture from the spray nozzle 73 is stopped, and the movement of the spray nozzle 73 is stopped. Further, during execution of the step S21, the spray nozzle 73 is returned to an initial position, and the lower-surface brush 51 is returned from the processing position to the waiting position. Thus, the process proceeds to the step S9 of the substrate cleaning process of Fig. 9.

### 7. Effects

In the substrate cleaning device 1 according to the present embodiment, in a case in which the lower-surface brush 51 is relatively largely spaced apart from the spray nozzle 73, the electropneumatic regulator 130 is controlled such that a load to be applied to the substrate W is relatively small. Therefore, the substrate W can be cleaned without deformation such as warpage or deflection of the substrate W.

On the other hand, in a case in which the lower-surface brush 51 and the spray nozzle 73 are relatively close to each other, the electropneumatic regulator 130 is controlled such that a load to be applied to the substrate W is relatively large. Even in this case, a load to be applied to the substrate W by the lower-surface brush 51 and a load to be applied to the substrate W by the spray nozzle 73 cancel each other, so that the substrate W is prevented from being largely deformed. Therefore, it is possible to firmly clean the substrate W without causing deformation of the substrate W.

Further, with this configuration, it is not necessary to move the lower-surface brush 51 and the spray nozzle 73 in synchronization with each other. Therefore, the procedure of cleaning for the substrate W is not limited. Thus, the substrate W can be cleaned efficiently. During cleaning for the substrate W, because the substrate W is rotated while being held by the lower holding device 20, a wide range of the lower surface and the upper surface of the substrate W can be easily cleaned.

The lower surface of the substrate W is cleaned when the cleaning surface of the lower-surface brush 51 comes into contact with the lower surface of the substrate W. In this case, the first surface of the substrate W can be cleaned in a short period of time. On the other hand, the upper surface of the substrate W is cleaned when the cleaning liquid is discharged from the spray nozzle 73. Further, the spray nozzle 73 is moved along the upper surface of the substrate W. Therefore, even in a case in which being a circuit forming surface, the upper surface of the substrate W can be appropriately cleaned.

In the present example, the distance threshold value L1 is equal to or smaller than the radius of the cleaning surface of the lower-surface brush 51 having a circular shape. In this case, when the lower-surface brush 51 and the spray nozzle 73 overlap with each other in plan view, a load to be applied to the substrate W by the lower-surface brush 51 or the spray nozzle 73 is increased. Thus, it is possible to clean the substrate W while more reliably preventing deformation of the substrate W.

A load to be applied to the substrate W is adjusted by control of a driving amount of the air cylinder 120 that presses the lower-surface brush 51 against the substrate W. In this case, an amount of pressure to be applied by the lower-surface brush 51 to the substrate W is adjusted by control of a driving amount of the air cylinder 120. Thus, it is possible to easily adjust a load to be applied to the substrate W.

Further, the lower-surface brush 51 waits at the waiting position during non-cleaning for the substrate W, and is lifted to the processing position close to the substrate W from the waiting position during cleaning for the substrate W. The lower-surface brush 51 is lifted and lowered between the waiting position and the processing position by the lifting-lowering motor 190. The lower-surface brush 51 located at the processing position is lifted and lowered by the air cylinder 120 in a range smaller than the range in which the lower-surface brush 51 is lifted and lowered by the lifting-lowering motor 190. Thus, the cleaning surface of the lower-surface brush 51 comes into contact with the lower surface of the substrate W.

With this configuration, the lower-surface brush 51 can be relatively largely lifted and lowered between the waiting position and the processing position by the lifting-lowering motor 190, and the lower-surface brush 51 can be lifted and lowered in a small range at the processing position by the air cylinder 120. Therefore, a load to be applied to the substrate W can be accurately adjusted with the lower-surface brush 51 located at the processing position during cleaning for the substrate W while the lower-surface brush 51 waits at the waiting position spaced apart from the processing position during non-cleaning for the substrate W.

### 8. Modified Example

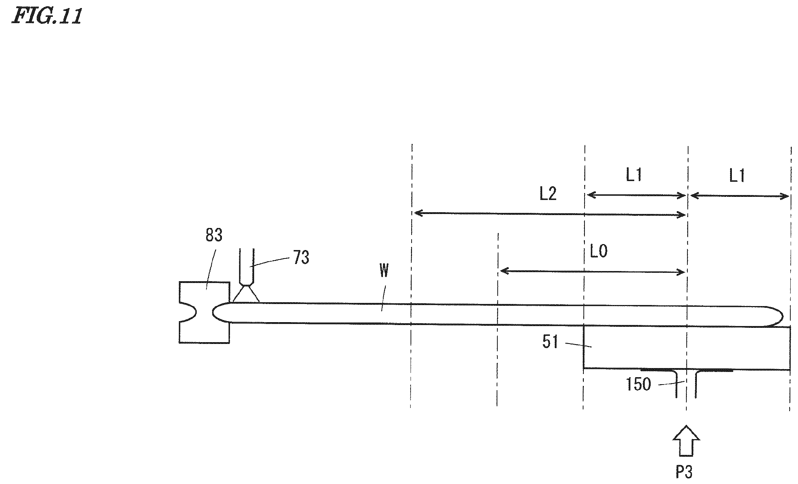

While the spray nozzle 73 is moved from a position above the center of the substrate W toward a position above the outer periphery of the substrate W during cleaning for the upper surface of the substrate W in the present embodiment, the embodiment is not limited to this. Fig. 11 is a diagram showing the movement of a spray nozzle 73 in a modified example. As shown in Fig. 11, during cleaning for the upper surface of a substrate W, above the substrate W, the spray nozzle 73 may be moved from a position on one side in the outer periphery of the substrate W toward a position on the other side in the outer periphery of the substrate W. In the example of Fig. 11, a lower-surface brush 51 is located below the position on the other side in the outer periphery of the substrate W.

In this case, in a case in which a lower distance between cleaners is larger than a predetermined distance threshold value L2, a load to be applied to the substrate W by the lower-surface brush 51 is adjusted to P3 smaller than P1. Here, the distance threshold value L2 is larger than the distance threshold value L1.

That is, in the modified example, in a case in which the distance between cleaners is larger than the distance threshold value L2, the load P3 is applied to the substrate W by the lower-surface brush 51. In a case in which the distance between cleaners is equal to or smaller than the distance threshold value L2 and is larger than the distance threshold value L1, the load P1 larger than the load P3 is applied to the substrate W by the lower-surface brush 51. In a case in which the distance between cleaners is equal to or smaller than the distance threshold value L1, a load P2 larger than the load P1 is applied to the substrate W by the lower-surface brush 51.

In the present example, the distance threshold value L2 is larger than a distance L0 between the center of the lower-surface brush 51 and the center of the substrate W in plan view. With this configuration, even in a case in which the lower-surface brush 51 and the spray nozzle 73 are largely spaced apart from each other, the substrate W can be cleaned without deformation of the substrate W.

Further, in the example of Fig. 11, a load is applied downwardly by the spray nozzle 73 to the upper surface at the position on the one side in the outer periphery of the substrate W. On the other hand, a load is applied upwardly to the lower surface at the position on the other side in the outer periphery of the substrate W. Also in this case, it is possible to more reliably prevent the substrate W from being detached from the suction holder 21.

In the example of Figs. 5 to 7 and Fig. 11, the direction in which the spray nozzle 73 is moved is not limited. Therefore, in Figs. 5 to 7, the spray nozzle 73 may be moved from a position above the outer periphery of the substrate W toward a position above the center of the substrate W. Further, in Fig. 11, above the substrate W, the spray nozzle 73 may be moved from a position on the other side in the outer periphery of the substrate W toward a position on the one side in the outer periphery of the substrate W.

### 9. Other Embodiments

(1) While a load to be applied to the substrate W by the lower-surface brush 51 is adjusted by control of the air cylinder 120 and the electropneumatic regulator 130 by the load controller 9G in the above-mentioned embodiment, the embodiment is not limited to this. The load controller 9G may control a liquid sending pressure of a pump 74. In this case, the liquid sending pressure of the pump is controlled, so that a pressure to be applied to the substrate W by the cleaning liquid discharged from the spray nozzle 73 is adjusted. Thus, it is possible to easily adjust a load to be applied to the substrate W.
(2) While a first cleaner is the lower-surface brush 51, and a second cleaner is the spray nozzle 73 in the above-mentioned embodiment, the embodiment is not limited to this. The first cleaner may be the lower-surface brush 51, and the second cleaner may be an upper-surface brush. Alternatively, the first cleaner may be a spray nozzle, and the second cleaner may be the spray nozzle 73. Further, the first cleaner may be a spray nozzle, and the second cleaner may be an upper-surface brush. Further, in a case in which the wide ranges of the upper surface and the lower surface of the substrate W can be cleaned, the substrate W does not have to be rotated during the double-side cleaning process.
(3) While the distance threshold value L1 is equal to or smaller than the radius of the lower-surface brush 51 in the above-mentioned embodiment, the embodiment is not limited to this. The distance threshold value L1 may be larger than the radius of the lower-surface brush 51. Further, although the distance threshold value L2 is larger than the distance L0 between the center of the lower-surface brush 51 and the center of the substrate W, the embodiment is not limited to this. The distance threshold value L2 may be equal to or smaller than the distance L0.
(4) In the above-mentioned embodiment, the lower-surface brush 51 is lifted and lowered between the waiting position and the processing position by the lifting-lowering motor 190, and the lower-surface brush 51 is slightly lifted and lowered by the air cylinder 120 when being located at the processing position. However, the embodiment is not limited to this. A common actuator may lift and lower the lower-surface brush 51 between the waiting position and the processing position, and may slightly lift and lower the lower-surface brush 51 when the lower-surface brush 51 is located at the processing position.
(5) While the outer peripheral end of the substrate W is also cleaned at the same time as the entire upper surface and the lower-surface outer area of the substrate W during the double-side cleaning process in the above-mentioned embodiment, the embodiment is not limited to this. The outer peripheral end of the substrate W does not have to be cleaned during the double-side cleaning process. Alternatively, the outer peripheral end of the substrate W does not have to be cleaned in the substrate cleaning device 1. In this case, the substrate cleaning device 1 does not have to include the end-portion cleaning device 80.
(6) While the substrate cleaning device 1 is configured to be capable of cleaning the lower-surface center area of the substrate W in the above-mentioned embodiment, the embodiment is not limited to this. The substrate cleaning device 1 does not have to be configured to be capable of cleaning the lower-surface center area of the substrate W. In this case, the substrate cleaning device 1 does not have to include the upper holding devices 10A, 10B, and does not have to include the receiving-transferring device 40.

### 10. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate W is an example of a substrate, the lower-surface brush 51 is an example of a first cleaner and a brush, and the spray nozzle 73 is an example of a second cleaner and a nozzle. The air cylinder 120 and the electropneumatic regulator 130 are examples of a load adjuster, and the pump 74 is another example of a load adjuster. The control device 9 is an example of a controller, the substrate cleaning device 1 is an example of a substrate cleaning device, the lower holding device 20 is an example of a substrate holder, the air cylinder 120 is an example of a first actuator, the lifting-lowering motor 190 is an example of a second actuator, and the pump 74 is an example of a pump.

### 11. Overview of Embodiments

(Item 1) A substrate cleaning device according to item 1 includes a first cleaner that cleans a first surface of a substrate, a second cleaner that cleans a second surface opposite to the first surface of the substrate, a load adjuster that adjusts a load to be applied to the substrate by the first cleaner or the second cleaner, and a controller that controls the load adjuster such that, in a case in which a distance between cleaners is larger than a predetermined first distance threshold value, a first load is applied to the substrate, and in a case in which the distance between cleaners is equal to or smaller than the first distance threshold value, a second load larger than the first load is applied to the substrate, the distance between cleaners being a distance between the first cleaner and the second cleaner in plan view.

In this substrate cleaning device, in a case in which the first cleaner and the second cleaner are relatively largely spaced apart from each other, the load adjuster is controlled such that a load to be applied to the substrate is relatively small. Therefore, the substrate can be cleaned without deformation such as warpage or deflection of the substrate.

On the other hand, in a case in which the first cleaner and the second cleaner are relatively close to each other, the load adjuster is controlled such that a load to be applied to the substrate is relatively large. Also in this case, a load to be applied to the substrate by the first cleaner and a load to be applied to the substrate by the second cleaner cancel each other, so that the substrate is prevented from being largely deformed. Therefore, it is possible to firmly clean the substrate without deformation of the substrate.

Further, with this configuration, it is not necessary to move the first cleaner and the second cleaner in synchronization with each other, so that the procedure of cleaning for the substrate is not limited. Thus, the substrate can be cleaned efficiently.

(Item 2) The substrate cleaning device according to item 1, may further include a substrate holder that holds and rotates the substrate.

In this case, the wide range of the first surface and the second surface of the substrate can be easily cleaned.

(Item 3) The substrate cleaning device according to item 1 or 2, wherein the first cleaner may include a brush that has a cleaning surface, and cleans the first surface by bringing the cleaning surface into contact with the first surface of the substrate.

In this case, the first surface of the substrate can be cleaned in a short period of time.

(Item 4) The substrate cleaning device according to item 3, wherein the cleaning surface of the brush may be circular, and the first distance threshold value may be equal to or smaller than a radius of the cleaning surface.

In this case, when the first cleaner and the second cleaner overlap with each other in plan view, a load to be applied to the substrate by the first cleaner or the second cleaner is increased. Thus, it is possible to clean the substrate while more reliably preventing deformation of the substrate.

(Item 5) The substrate cleaning device according to item 3 or 4, wherein the load adjuster may include a first actuator that presses the brush against the substrate, and the controller may adjust a load to be applied to the substrate by controlling a driving amount of the first actuator.

In this case, an amount of pressure to be applied from the brush to the substrate is adjusted by control of a driving amount of the first actuator. Thus, it is possible to easily adjust a load to be applied to the substrate.

(Item 6) The substrate cleaning device according to item 5, may further include a second actuator that lifts and lowers the brush between a waiting position at which the brush waits during non-cleaning for the substrate and a processing position that is located closer to the substrate than the waiting position, wherein the first actuator may bring the cleaning surface of the brush into contact with the first surface of the substrate by lifting and lowering the brush located at the processing position in a range smaller than a range in which the brush is lifted and lowered by the second actuator.

In this case, the brush can be relatively largely lifted and lowered between the waiting position and the processing position by the second actuator, and the brush can be slightly lifted and lowered at the processing position by the first actuator. Thus, a load to be applied to the substrate can be accurately adjusted with the brush located at the processing position during cleaning for the substrate while the brush waits at the waiting position spaced apart from the processing position during non-cleaning for the substrate.

(Item 7) The substrate cleaning device according to any one of items 1 to 6, wherein the second cleaner may include a nozzle that cleans the second surface by discharging a cleaning liquid while moving along the second surface of the substrate.

With this configuration, even in a case in which a circuit is formed on the second surface of the substrate, the second surface can be appropriately cleaned.

(Item 8) The substrate cleaning device according to item 7, wherein the load adjuster may include a pump that pumps the cleaning liquid and discharges the cleaning liquid from the nozzle, and the controller may adjust a load to be applied to the substrate by controlling a liquid sending pressure of the pump.

In this case, the liquid sending pressure of the pump is controlled, so that a pressure to be applied to the substrate by the cleaning liquid discharged from the nozzle is adjusted. Thus, it is possible to easily adjust a load to be applied to the substrate.

(Item 9) The substrate cleaning device according to any one of items 1 to 8, wherein the controller may control the load adjuster such that, in a case in which the distance between cleaners is larger than a predetermined second distance threshold value, a third load smaller than the first load is applied to the substrate, and the second distance threshold value may be larger than the first distance threshold value.

With this configuration, even in a case in which the first cleaner and the second cleaner are more largely spaced apart from each other, it is possible to clean the substrate without deformation of the substrate.

(Item 10) The substrate cleaning device according to item 9, wherein the first cleaner may clean an area spaced apart from a center of the substrate in the first surface of the substrate, and the second distance threshold value may be larger than a distance between the first cleaner and the center of the substrate in the plan view.

With this configuration, even in a case in which the first cleaner and the second cleaner are even more largely spaced apart from each other, it is possible to clean the substrate without deformation of the substrate.

(Item 11) A substrate cleaning method according to item 11 including cleaning a first surface of a substrate using a first cleaner, cleaning a second surface opposite to the first surface of the substrate using a second cleaner, adjusting, using a load adjuster, a load to be applied to the substrate by the first cleaner or the second cleaner to a first load in a case in which a distance between cleaners is larger than a predetermined first distance threshold value, the distance between cleaners being a distance between the first cleaner and the second cleaner in plan view, and adjusting, using the load adjuster, a load to be applied to the substrate by the first cleaner or the second cleaner to a second load larger than the first load in a case in which the distance between cleaners is equal to or smaller than the first distance threshold value.

With this substrate cleaning method, it is possible to clean the substrate without deformation of the substrate. Further, it is not necessary to move the first cleaner and the second cleaner in synchronization with each other, the procedure of cleaning for the substrate is not limited. Thus, the substrate can be cleaned efficiently.

## Claims

1. A substrate cleaning device comprising:
a first cleaner that cleans a first surface of a substrate;
a second cleaner that cleans a second surface opposite to the first surface of the substrate;
a load adjuster that adjusts a load to be applied to the substrate by the first cleaner or the second cleaner; and
a controller that controls the load adjuster such that, in a case in which a distance between cleaners is larger than a predetermined first distance threshold value, a first load is applied to the substrate, and in a case in which the distance between cleaners is equal to or smaller than the first distance threshold value, a second load larger than the first load is applied to the substrate, the distance between cleaners being a distance between the first cleaner and the second cleaner in plan view.

2. The substrate cleaning device according to claim 1, further comprising a substrate holder that holds and rotates the substrate.

3. The substrate cleaning device according to claim 1 or 2, wherein
the first cleaner includes a brush that has a cleaning surface, and cleans the first surface by bringing the cleaning surface into contact with the first surface of the substrate.

4. The substrate cleaning device according to claim 3, wherein
the cleaning surface of the brush is circular, and
the first distance threshold value is equal to or smaller than a radius of the cleaning surface.

5. The substrate cleaning device according to claim 3 or 4, wherein
the load adjuster includes a first actuator that presses the brush against the substrate, and
the controller adjusts a load to be applied to the substrate by controlling a driving amount of the first actuator.

6. The substrate cleaning device according to claim 5, further comprising a second actuator that lifts and lowers the brush between a waiting position at which the brush waits during non-cleaning for the substrate and a processing position that is located closer to the substrate than the waiting position, wherein
the first actuator brings the cleaning surface of the brush into contact with the first surface of the substrate by lifting and lowering the brush located at the processing position in a range smaller than a range in which the brush is lifted and lowered by the second actuator.

7. The substrate cleaning device according to any one of claims 1 to 6, wherein
the second cleaner includes a nozzle that cleans the second surface by discharging a cleaning liquid while moving along the second surface of the substrate.

8. The substrate cleaning device according to claim 7, wherein
the load adjuster includes a pump that pumps the cleaning liquid and discharges the cleaning liquid from the nozzle, and
the controller adjusts a load to be applied to the substrate by controlling a liquid sending pressure of the pump.

9. The substrate cleaning device according to any one of claims 1 to 8, wherein
the controller controls the load adjuster such that, in a case in which the distance between cleaners is larger than a predetermined second distance threshold value, a third load smaller than the first load is applied to the substrate, and
the second distance threshold value is larger than the first distance threshold value.

10. The substrate cleaning device according to claim 9, wherein
the first cleaner cleans an area spaced apart from a center of the substrate in the first surface of the substrate, and
the second distance threshold value is larger than a distance between the first cleaner and the center of the substrate in the plan view.

11. A substrate cleaning method including:
cleaning a first surface of a substrate using a first cleaner;
cleaning a second surface opposite to the first surface of the substrate using a second cleaner;
adjusting, using a load adjuster, a load to be applied to the substrate by the first cleaner or the second cleaner to a first load in a case in which a distance between cleaners is larger than a predetermined first distance threshold value, the distance between cleaners being a distance between the first cleaner and the second cleaner in plan view; and
adjusting, using the load adjuster, a load to be applied to the substrate by the first cleaner or the second cleaner to a second load larger than the first load in a case in which the distance between cleaners is equal to or smaller than the first distance threshold value.
